# FASCICULE DE BREVET EUROPEEN

(11) **EP 1 409 405 B1**
(45) Date de publication et mention de la délivrance du brevet: **15.12.2010**
(21) Numéro de dépôt: 02767590.9
(22) Date de dépôt: 22.07.2002
(51) Int. Cl.: C01B 33/037

(54) **SILICIUM METALLURGIQUE DE HAUTE PURETE ET PROCEDE D'ELABORATION**
METALLURGISCHES SILIZIUM HOHER REINHEIT UND VERFAHREN ZU SEINER HERSTELLUNG
HIGH-PURITY METALLURGICAL SILICON AND PROCESS FOR PREPARATION THEREOF

(30) Priorité: 23.07.2001 FR 0109788
(43) Date de publication de la demande: 21.04.2004
(73) Titulaire: FERROPEM, 73000 Chambery (FR); CENTRE NATIONAL DE LA RECHERCHE SCIENTIFIQUE (CNRS), 75794 Paris Cedex 16 (FR)
(72) Inventeur: BALUAIS, Gérard, 73000 Chambery (FR); CARATINI, Yves, F-74190 Chedde (FR); DELANNOY, Yves, F-38920 Crolles (FR); TRASSY, Christian, F-38100 Grenoble (FR)
(74) Mandataire: Maureau, Philippe
(86) Numéro de dépôt international: PCT/FR2002/002602
(87) Numéro de publication internationale: WO 2003/014019

(56) Documents cités:
- EP-A- 0 459 421
- EP-A- 0 477 784
- FR-A- 2 772 741
- US-A- 4 193 975
- US-A- 4 837 376
- DATABASE WPI Section Ch, Week 199234 Derwent Publications Ltd., London, GB; Class E36, AN 1992-281549 XP002194088 & JP 04 193706 A (KAWASAKI STEEL CORP), 13 juillet 1992 (1992-07-13)

## Description

### Domaine de l'invention

L'invention concerne un procédé d'élaboration de silicium métallurgique de haute pureté dont une des applications est la fabrication de panneaux pour conversion de l'énergie lumineuse, en particulier l'énergie solaire, en énergie électrique désigné sous le terme de silicium photovoltaïque.

### Etat de la technique

Les applications du silicium de haute pureté sont multiples et requièrent chacune des spécifications particulières. La pureté requise par l'application photovoltaïque peut s'étendre sur un domaine relativement large, car le rendement énergétique et le comportement au vieillissement des cellules solaires dépendent de la qualité du silicium haute pureté mis en oeuvre, ce qui laisse aux fabricants de panneaux solaires des possibilités de choix en matière de rapport qualité / prix.

Les produits déclassés issus de la fabrication de silicium électronique ont constitué pendant longtemps la principale source de silicium de qualité photovoltaïque, mais cette source s'avère insuffisante pour fournir la demande croissante du marché, ce qui nécessite de se tourner vers d'autres sources de silicium, comme le silicium métallurgique élaboré par réduction carbothermique de la silice au four électrique à arc, et utilisé principalement comme matière première en chimie et comme élément d'alliage de l'aluminium. La qualité de silicium métallurgique utilisé pour la synthèse des chlorosilanes, matière première de la fabrication des silicones, présente toutefois des spécifications très éloignées de celles du silicium photovoltaïque, et on ne peut envisager son emploi dans cette application qu'avec un affinage poussé. Le coût de cet affinage croît très vite avec le niveau de pureté ; ainsi, le silicium de qualité électronique a un coût de l'ordre de 30 fois celui du silicium métallurgique. Les spécifications requises par l'application photovoltaïque dépendent des qualités demandées au niveau des cellules : les meilleures performances requièrent un silicium répondant à la spécification : Bore < 3 ppm, Phosphore < 10 ppm,

Total des impuretés métalliques < 300 ppm, et de préférence < 150 ppm.

Le coût de l'affinage pour obtenir ce niveau de pureté reste élevé et peu compétitif pour l'application photovoltaïque. Parmi les techniques d'affinage du silicium liquide, on a vu se développer progressivement l'affinage par plasma qui permet de descendre les teneurs en bore et phosphore jusqu'à des valeurs de quelques ppm.

Le brevet FR 2585690 de Rhône-Poulenc Spécialités Chimiques décrit un affinage en deux temps comprenant une fusion sous plasma avec comme gaz plasmagène un mélange hydrogène - argon, puis un affinage sous plasma avec comme gaz un mélange hydrogène - argon - oxygène. Cette technique présente plusieurs inconvénients :
- celui de mettre en oeuvre de l'hydrogène à haute température, ce qui, dans une mise en oeuvre industrielle du procédé, peut entraîner des fuites d'hydrogène, et donc des problèmes de sécurité difficiles à résoudre.
- celui de réaliser une fusion sous plasma dont la productivité est faible.
- celui de mettre en oeuvre de l'oxygène qui génère du laitier pendant le traitement, lequel laitier constitue une barrière entre le silicium liquide en cours d'affinage et les constituants du plasma, ce qui ralentit la cinétique de l'affinage. En outre, ce laitier se rassemble progressivement sur les bords du creuset pour former un anneau de crasses solides au niveau de l'affleurement du liquide, ce qui nécessite un décrassement ultérieur. Au fil des opérations, ces décrassements successifs endommagent et fragilisent les creusets et réduisent leur durée de vie.

Le brevet EP 0.459.421 (Kawasaki Steel) décrit l'affinage du silicium par plasma en creuset siliceux, ou revêtu d'un garnissage réfractaire siliceux, en utilisant comme gaz plasmagène un gaz inerte additionné de 0,1 à 10% de vapeur d'eau, et, de façon facultative, de poudre de silice dans une proportion inférieure à 1 kg de silice par Nm³ de gaz.

Comme dans le cas précédent, ce mode opératoire favorise la formation d'un film d'oxyde à la surface du silicium, ce qui a pour conséquence de ralentir la cinétique de l'affinage. Le brevet précise même qu'il convient d'éviter de dépasser une teneur en oxygène de 0,05% dans le silicium fondu.

De plus, le fait d'opérer avec une torche à plasma soufflé ou à plasma transféré constitue un apport d'impuretés au niveau du silicium, car l'usure de la cathode de la torche due à la volatilisation du métal dont elle est constituée contribue à polluer le plasma formé, qui à son tour contamine le silicium.

Le brevet FR 2.772.741 du CNRS décrit un affinage du silicium liquide avec un mélange gazeux chlore - hydrogène - vapeur d'eau, qui présente les mêmes inconvénients que le cas précédent, en particulier une vitesse de fusion du silicium solide très lente, avec en outre le désavantage de travailler avec un creuset froid, qui engendre des pertes thermiques importantes et conduit à des consommations d'énergie très élevées de l'ordre de 50 000 kWh/t à 100 000 kWh/t, alors que la fabrication du silicium liquide par carboréduction de la silice peut se satisfaire de 8100 kWh/t, et que la fusion du silicium solide ne nécessite que 900 kWh/t. En outre le recours à la technique du creuset froid ne permet pas de concevoir des outils de taille industrielle.

L'invention a donc pour but d'obtenir un silicium, issu de silicium métallurgique, de pureté acceptable pour l'utilisation comme matériau photovoltaïque, ainsi qu'un procédé économique d'élaboration industrielle de ce matériau à partir de silicium métallurgique.

### Objet de l'invention

L'invention a pour objet un procédé de fabrication d'un silicium destiné notamment à la fabrication de cellules solaires contenant un total d'impuretés compris entre 100 et 400 ppm, et de préférence entre 100 et 250 ppm, une teneur en éléments métalliques comprise entre 30 et 300 ppm et de préférence entre 30 et 150 ppm, une teneur en bore comprise entre 0,5 et 3 ppm, et de préférence entre 0,5 et 2 ppm, et un rapport entre teneur en phosphore et bore compris entre 1 et 3 désigné sous le terme de silicium photovoltaïque à partir d'un silicium métallurgique affiné à l'oxygène ou au chlore et contenant moins de 500 ppm d'éléments métalliques, comportant :
- la refusion sous atmosphère neutre du silicium solide à moins de 500 ppm d'éléments métalliques au four électrique équipé d'un creuset chaud,
- le transfert du silicium fondu, pour réaliser un affinage sous plasma, dans un four électrique équipé d'un creuset chaud,
- l'affinage sous plasma avec comme gaz plasmagène un mélange d'argon et d'au moins un gaz du groupe constitué par le chlore, le fluor, l'acide chlorhydrique et l'acide fluorhydrique,
- la coulée sous atmosphère contrôlée dans une lingotière où est réalisée une solidification ségrégée.

La préparation d'un silicium métallurgique à moins de 500 ppm d'éléments métalliques se fait de préférence par une première opération de solidification ségrégée.

### Description de l'invention

Les recherches menées par la demanderesse ont permis de montrer qu'on pouvait, sous certaines conditions et pour certains éléments, se contenter pour le silicium photovoltaïque, d'un degré de pureté moindre que pour le silicium de qualité électronique, tout en obtenant de bonnes performances pour les cellules photovoltaïques.

Ainsi, le phosphore apparaît comme un élément sensiblement moins perturbant que le bore et, sans trop dégrader la performance des cellules, on peut accepter une teneur en phosphore jusqu'à 10 ppm. Par ailleurs, les impuretés autres que les éléments des groupes III et V de la classification de Mendeleïev ont une importance mineure sur les performances des cellules et un silicium contenant un total des impuretés de moins de 400 ppm, une teneur en bore comprise entre 0,5 et 3 ppm et une teneur en phosphore comprise entre 1 et 3 fois la teneur en bore donne d'excellents résultats, à condition que le total des impuretés métalliques reste inférieur à 300 ppm, et de préférence à 150 ppm.

Un tel matériau présente donc un grand intérêt si l'on parvient à le produire à un coût compétitif, c'est-à-dire très inférieur à celui du silicium de qualité électronique. Le procédé de fabrication selon l'invention répond à cette exigence. La matière première de base est le silicium métallurgique produit industriellement par réduction carbothermique du quartz au four électrique à arc, et plus précisément la qualité « chimie » destinée à la synthèse des chlorosilanes pour la fabrication des silicones.

Cette qualité s'obtient à l'aide d'un affinage oxydant du silicium métallurgique à l'état liquide et permet d'atteindre des spécifications telles que par exemple : Fe < 0,30% ; Ca < 0,10% ; Al < 0,30%. Les teneurs en bore se situent en général entre 20 et 50 ppm et les teneurs en phosphore entre 30 et 100 ppm. Ce type de matériau contient également d'autres impuretés, en particulier titane, carbone et oxygène, mais aussi vanadium, chrome, manganèse, nickel et cuivre à l'état de traces.

La mise en oeuvre d'un procédé d'affinage au chlore tel que celui décrit par la demanderesse dans le brevet EP 0.720.967 permet d'atteindre déjà sur silicium liquide des niveaux d'oxygène de 400 ppm. L'expérience a montré en outre que ce type d'affinage permet également d'atteindre des niveaux de carbone de l'ordre de 100 ppm.

Par ailleurs l'accès à des matières premières à bas fer, ainsi que le développement de la technologie des électrodes composites, permet aujourd'hui une diminution significative des teneurs en fer du silicium métallurgique ; en outre la technique de ségrégation lors de la solidification permet également, s'il le faut, de diminuer encore notablement les teneurs en fer de ce type de silicium.

Après ce premier affinage à l'oxygène ou au chlore, on procède si nécessaire à une solidification ségrégée pour séparer un silicium solide à moins de 500 ppm d'éléments métalliques et concentrer les impuretés métalliques dans un silicium liquide enrichi contenant de 0,5 à 1% d'éléments métalliques. Le refroidissement de la masse coulée est contrôlé pour limiter la vitesse de progression du front qui doit rester inférieure à 2.10⁻⁵ m/s, et de préférence à 10⁻⁵ m/s; et on obtient de 48 à 52% de silicium solide à moins de 500 ppm d'éléments métalliques.

On procède ensuite à une refusion par lots sous atmosphère neutre, par exemple d'argon, au four électrique, de préférence à induction, du silicium solide à moins de 500 ppm d'éléments métalliques , en creuset chaud classique, soit en carbone, en graphite ou en carbure de silicium, soit avec un garnissage réfractaire constitué de silice frittée. Le générateur électrique alimentant le four à induction travaille à des fréquences dépendant du diamètre du creuset, et typiquement comprises entre 500 et 5000 Hz. Un pied de bain est conservé après chaque coulée pour faciliter le redémarrage de l'opération suivante.

On transfère ensuite le silicium fondu dans un second four électrique, de préférence à induction, équipé du même type de creuset pour réaliser l'affinage sous plasma. Le plasma est obtenu par une torche inductive alimentée par une source de tension électrique de fréquence comprise entre 100 kHz et 4 MHz. Le gaz plasmagène utilisé pour réaliser l'opération est constitué d'un mélange d'argon et de chlore, de fluor, d'acide chlorhydrique ou fluorhydrique, la proportion d' argon utilisé étant comprise entre 5 et 90%, et de préférence entre 50 et 70%. Dans ces conditions l'affinage du silicium donne lieu à la formation de composés gazeux, ce qui évite la formation de crasses liquides ou solides dans le creuset du four. Pour favoriser le démarrage de l'opération, on peut ajouter un peu de chlorure de magnésium anhydre à la surface du silicium, sans que cela ne perturbe l'affinage.

On procède ensuite à la coulée sous atmosphère inerte contrôlée dans une lingotière où est réalisée une seconde opération de solidification ségrégée ; le refroidissement de la masse coulée est contrôlée pour, à ce stade du procédé, limiter la vitesse de progression du front qui doit rester inférieure à 10⁻⁵ m/s et de préférence inférieure à 5.10⁻⁶ m/s. La proportion de silicium solide obtenu à moins de 300 ppm d'impuretés métalliques se situe entre 80% et 86%, et la proportion de silicium liquide restant, enrichi en éléments métalliques, se situe entre 14% et 20%.

Le transfert du silicium liquide entre l'opération de refusion et l'opération d'affinage sous plasma est réalisée de préférence par déplacement de l'ensemble constitué par la carcasse du four à induction contenant inducteur, creuset et silicium liquide, depuis la station de refusion jusqu'à la station de traitement sous plasma. Cet ensemble est construit de façon à pouvoir être rapidement débroché et re-embroché sur les générateurs électriques statiques à 500 Hz - 5000 Hz dont sont équipés à la fois le poste de fusion et le poste de traitement plasma. Ce dernier est équipé en plus d'une torche plasma inductive fixe et de son générateur électrique, fixe également. Cet agencement du matériel et cette façon de faire ont pour objet d'éviter un transvasement de silicium liquide.

L'ensemble de la filière permet de préparer à partir de silicium à 0,25% de fer, 0,10% de calcium, 0,30% d'aluminium , 20 à 50 ppm de bore et 30 à 100 ppm de phosphore, environ 48 à 52% de silicium contenant de 0,5 à 1% d'impuretés métalliques, 7 à 10% de silicium contenant de 500 à 1500 ppm d'impuretés métalliques et 40 à 43% de silicium haute pureté selon l'invention.

La consommation d'énergie est d'environ 7000 kWh/t de silicium haute pureté, à laquelle il faut ajouter les quelques 11000 kWh/t nécessaires à l'élaboration du matériau de base, ce qui donne un total de l'ordre de 18000 kWh/t pour le silicium haute pureté obtenu.

Le silicium haute pureté obtenu par ce procédé présente la composition suivante :
Bore : 0,5 à 3 ppm ; Phosphore/Bore entre 1 et 3 ;
Total des impuretés : 100 à 400 ppm,
Total des impuretés métalliques : 30 à 300 ppm, Fe : 10 à 200 ppm,
Carbone : 20 à 50 ppm ; Oxygène : 50 à 100 ppm ;
Calcium :5 à 30 ppm ; Aluminium : 5 à 30 ppm ; Titane : 2 à 20 ppm.

En augmentant la durée du traitement sous plasma, on peut obtenir un silicium haute pureté de qualité sensiblement meilleure telle que:
Bore : 0,5 à 2 ppm ; Phosphore/Bore entre 1 et 3 ;
Total des impuretés : 100 à 250 ppm,
Total des impuretés métalliques : 30 à 150 ppm, Fe : 10 à 20 ppm,
Carbone : 10 à 30 ppm ; Oxygène : 20 à 50 ppm ;
Calcium : 5 à 10 ppm ; Aluminium : 5 à 10 ppm ; Titane : 2 à 5 ppm.

### Exemples

### Exemple 1

Sur la production de silicium d'un four électrique à arc submergé, on a prélevé une poche de 2 t de silicium liquide qui a fait l'objet d'un affinage oxydant ; le silicium liquide échantillonné dans la poche a donné à l'analyse ICP :
Fer = 0,24 % ; Calcium : 98 ppm ; Aluminium : 245 ppm ; Titane : 240 ppm ;
Bore 32 ppm ; Phosphore : 19 ppm ; Carbone : 100 ppm ; oxygène : 1200 ppm.

Une partie de ce silicium liquide a été versé dans une lingotière en silice frittée équipée d'un bec de coulée, d'une capacité de 600 kg de silicium ; cette lingotière, d'une surface de 2 m², a été placée dans un four à réverbère chauffé électriquement au moyen de barreaux en graphite servant de résistances, les fuites thermiques du four se faisant principalement par la sole. La puissance du four a été ajustée à 40 kW pour obtenir une solidification de 50% du silicium en environ 1,25 h. Après 75 minutes d'attente, le liquide restant dans la lingotière a été coulé par le bec et a donné un lingot de 290 kg.

Le silicium solide restant en lingotière, d'une masse de 294 kg a donné à l'analyse : Fer = 285 ppm ; Calcium : 24 ppm ; Aluminium : 14 ppm ; Titane : 9 ppm ; Bore 28 ppm ; Phosphore : 10 ppm ; Carbone : 100 ppm ; Oxygène : 800 ppm. Pour disposer d'une quantité suffisante de silicium de cette qualité, l'opération a été refaite plusieurs fois.

Le silicium obtenu a été refondu par lots de 200 kg sous atmosphère d'argon en four à induction de 250 kW travaillant à 1200 Hz en démarrant avec un pied de bain de silicium liquide métallurgique ; la production des trois premiers lots à été rejetée pour s'assurer d'un rinçage correct du four.

La production des lots suivants a été transférée lot par lot pour traitement d'affinage du poste de refusion vers le poste de traitement plasma par transfert complet de l'ensemble de la carcasse du four, de l'inducteur, du creuset et du silicium liquide. Le poste de traitement plasma est équipé d'un générateur identique à celui de la station de refusion et d'un ensemble fixe comportant une torche plasma inductive et un générateur à 150 kHz. La torche est alimentée par un mélange gazeux constitué de 40% de HCl et 60% d'argon. La durée du traitement a été de 1 h par lot.

Chaque lot de silicium traité sous plasma a ensuite fait l'objet d'une solidification ségrégée dans une lingotière de 0,67 m² équipée d'un bec de coulée et placée dans un four à réverbère chauffé électriquement au moyen de barreaux en graphite servant de résistances , les fuites thermiques du four se faisant principalement par la sole. La puissance du four a été maintenue à 45 kW. La coulée du liquidus a été réalisée après 3 heures d'attente . La masse coulée a donné un lingot de 36 kg, alors que la masse de silicium solidifiée récupérée a été de 162 kg.

Le silicium brut de traitement plasma a fait l'objet d'un échantillonnage sur liquide ; les analyses ont donné :
Fer = 280 ppm ; Calcium : 23 ppm ; Aluminium : 14 ppm ; Titane : 9 ppm ;
Bore 3 ppm ; Phosphore : 8 ppm ; Carbone : 50 ppm ; Oxygène : 80 ppm.

Le silicium solide obtenu après ségrégation effectuée après affinage plasma a donné à l'analyse :
Fer = 160 ppm ; Calcium : 9 ppm ; Aluminium : 8 ppm ; Titane : 5 ppm ;
Bore 3 ppm ; Phosphore : 8 ppm ; Carbone : 50 ppm ; Oxygène : 90 ppm.

### Exemple 2

L'essai de l'exemple 1 a été refait en cherchant à pousser le procédé au maximum de ses possibilités en terme de qualité du silicium final.

Sur la production de silicium d'un four électrique à arc submergé, on a prélevé une poche de 2 t de silicium liquide qui a fait l'objet d'un traitement d'affinage au chlore; le silicium liquide échantillonné dans la poche a donné à l'analyse :
Fer = 0,25 % ; Calcium : 90 ppm ; Aluminium : 210 ppm ; Titane : 240 ppm ;
Bore 32 ppm ; Phosphore : 20 ppm ; Carbone : 100 ppm ; Oxygène : 400 ppm.

Cette poche a ensuite été traitée sous pression réduite pendant 30 minutes avec injection d'argon en fond de poche à travers une brique poreuse ; le débit de d'argon était de 0,7 Nm³ / heure.

Une partie du silicium liquide ainsi obtenu a été versé dans une lingotière en silice frittée équipée d'un bec de coulée, d'une capacité de 600 kg de silicium ; cette lingotière, d'une surface de 2 m², a été placée dans un four à réverbère chauffé électriquement au moyen de barreaux en graphite servant de résistances, les fuites thermiques du four se faisant principalement par la sole. La puissance du four a été ajustée à 50 kW pour obtenir dans la lingotière une solidification d'environ 50% du silicium en 2,5 h.

Après 150 minutes d'attente, le liquide restant dans la lingotière a été coulé par le bec et a donné un lingot de 290 kg. Le silicium solide restant en lingotière, d'une masse de 295 kg, a donné à l'analyse :
Fer = 95 ppm ; Calcium : 23 ppm ; Aluminium : 12 ppm ; Titane : 9 ppm ;
Bore 32 ppm ; Phosphore : 6 ppm ; Carbone : 100 ppm ; Oxygène : 400 ppm.
Pour disposer d'une quantité suffisante de silicium de cette qualité, l'opération a été refaite plusieurs fois.

Le silicium obtenu a été refondu par lots de 200 kg sous atmosphère d'argon en four à induction de 250 kW travaillant à 1000 Hz, en démarrant avec un pied de bain de silicium liquide métallurgique ; la production des trois premiers lots à été rejetée pour s'assurer d'un rinçage correct du four.

La production des lots suivants a été transférée lot par lot pour traitement d'affinage dans les mêmes conditions que dans l'exemple 1. La durée du traitement a été de 2 h par lot.

Chaque lot de silicium traité sous plasma a ensuite fait l'objet d'une solidification ségrégée dans une lingotière de 0,67 m² équipée d'un bec de coulée et placée dans un four à réverbère chauffé électriquement au moyen de barreaux en graphite servant de résistances , les fuites thermiques du four se faisant principalement par la sole. La puissance du four a été maintenue à 55 kW. La coulée du liquidus a été réalisée après 6 heures d'attente . La masse coulée a donné un lingot de 30 kg, alors que la masse de silicium solidifiée récupérée a été de 164 kg.

Le silicium brut de traitement plasma a fait l'objet d'un échantillonnage sur liquide ; les analyses ont donné :
Fer = 85 ppm ; Calcium : 23 ppm ; Aluminium : 12 ppm ; Titane : 9 ppm ;
Bore 2 ppm ; Phosphore : 5 ppm ; Carbone : 30 ppm ; Oxygène : 50 ppm.

Le silicium solide obtenu après ségrégation post affinage plasma a donné à l'analyse :
Fer = 16 ppm ; Calcium : 9 ppm ; Aluminium : 7 ppm ; Titane : 4 ppm ;
Bore 2 ppm ; Phosphore : 5 ppm ; Carbone : 30 ppm ; Oxygène : 50 ppm.

## Revendications

1. Procédé d'élaboration de silicium de qualité photovoltaïque à partir de silicium métallurgique affiné à l'oxygène ou au chlore et contenant moins de 500 ppm d'éléments métalliques, comportant :
- la refusion du silicium affiné, sous atmosphère neutre, au four électrique équipé d'un creuset chaud,
- le transfert du silicium refondu, pour réaliser un affinage sous plasma, dans un four électrique équipé d'un creuset chaud,
- l'affinage sous plasma du silicium refondu avec comme gaz plasmagène un mélange d'argon et d'au moins un gaz appartenant au groupe constitué par le chlore, le fluor, l'acide chlorhydrique et l'acide fluorhydrique, le mélange contenant de 5 à 90% d'argon,
- la coulée sous atmosphère contrôlée dans une lingotière où est réalisée une solidification ségrégée.

2. Procédé selon la revendication 1, **caractérisé en ce que** la préparation du silicium à moins de 500 ppm d'éléments métalliques se fait par solidification ségrégée de manière à concentrer les impuretés métalliques dans la fraction liquide.

3. Procédé selon l'une des revendications 1 ou 2, **caractérisé en ce que** la refusion se fait par lots successifs.

4. Procédé selon l'une des revendications 1 à 3, **caractérisé en ce que** la refusion et l'affinage sous plasma du silicium sont réalisés dans deux stations de travail différentes.

5. Procédé selon l'une des revendications 1 à 4, **caractérisé en ce que** le transfert du silicium entre la refusion et l'affinage sous plasma se fait sans transvasement par déplacement d'un ensemble constitué par la carcasse du four, l'inducteur, le creuset et le silicium liquide.

6. Procédé selon l'une des revendications 1 à 5, **caractérisé en ce que** l'affinage sous plasma est réalisé avec un mélange gazeux HF-argon et/ou HCl-argon contenant de 50 à 70% d'argon.

7. Procédé selon l'une des revendications 1 à 6, **caractérisé en ce que** la source de plasma est une torche inductive alimentée par une source de tension électrique de fréquence comprise entre 100 kHz et 4 MHz.

8. Procédé selon l'une des revendications 2 à 7, **caractérisé en ce que** la première solidification ségrégée, avant affinage plasma, est conduite avec une vitesses de progression du front de solidification inférieure à 2.10⁻⁵ m/s.

9. Procédé selon l'une des revendications 1 à 8, **caractérisé en ce que** la solidification ségrégée après affinage plasma est conduite avec une vitesse de progression du front de solidification inférieure à 10⁻⁵ m/s.

10. Procédé selon la revendication 9, **caractérisé en ce que** la vitesse de progression du front de solidification est inférieure à 5.10⁻⁶ m/s.

11. Procédé selon l'une des revendications 1 à 10, **caractérisé en ce que** les opérations de solidification ségrégée sont faites dans un four à réverbère.

12. Procédé selon l'une des revendications 1 à 11, **caractérisé en ce que** les fours électriques mis en oeuvre pour la refusion et l'affinage plasma du silicium sont des fours à induction.

13. Procédé selon l'une des revendications 1 à 12, **caractérisé en ce que** les creusets de fours électriques mis en oeuvre pour la refusion et l'affinage plasma du silicium sont en silice, en carbone, en graphite ou en carbure de silicium.

## Claims

1. A method for elaborating silicon of photovoltaic quality from metal silicon refined with oxygen or chlorine and containing less than 500 ppm of metal elements, including
- re-melting of refined silicon, under a neutral atmosphere, in an electric furnace equipped with a hot crucible,
- transfer of the re-molten silicon in order to achieve refining under a plasma, in an electric furnace equipped with a hot crucible,
- refining under plasma of the re-molten silicon with, as a plasmagenic gas, a mixture of argon and of at least one gas belonging to the group formed by chlorine, fluorine, hydrochloric acid and hydrofluoric acid, the mixture containing from 5 to 90% of argon,
- casting under a controlled atmosphere into an ingot mold where segregated solidification is achieved.

2. The method according to claim 1, **characterized in that** the preparation of silicon with less than 500 ppm of metal elements is accomplished by segregated solidification so as to concentrate the metal impurities in the liquid fraction.

3. The device according to claim 1 or 2, **characterized in that** re-melting is accomplished with successive batches.

4. The method according to claims 1 to 3, **characterized in that** re-melting and plasma refining of the silicon are achieved in two different work stations.

5. The method according to any of claims 1 to 4, **characterized in that** the transfer of the silicon between the re-melting and the plasma refining is accomplished without decanting by displacement of an assembly formed by the shell of the furnace, the inductor, the crucible and the liquid silicon.

6. The method according to any of claims 1 to 5, **characterized in that** the refining under plasma is achieved with an HF-argon and/or HCl-argon gas mixture containing from 50 to 70% of argon.

7. The method according to any of claims 1 to 6, **characterized in that** the plasma source is an inductive torch powered by an electric voltage source with a frequency comprised between 100 kHz and 4 MHz.

8. The method according to any of claims 2 to 7, **characterized in that** the first segregated solidification before plasma refining is conducted with a rate of progression of the solidification front of less than 2.10⁻⁵ m/s.

9. The method according to any of claims 1 to 8, **characterized in that** the first segregated solidification after plasma refining is conducted with a rate of progression of the solidification front of less than 10⁻⁵ m/s.

10. The method according to claim 9, **characterized in that** the rate of progression of the solidification front is less than 5.10⁻⁶ m/s.

11. The method according to any of claims 1 to 10, **characterized in that** the segregated solidification operations are accomplished in a reverberatory furnace.

12. The method according to any of claims 1 to 11, **characterized in that** the electric furnaces applied for re-melting and plasma refining of the silicon are induction furnaces.

13. The method according to any of claims 1 to 12, **characterized in that** the crucibles of electric furnaces applied for re-melting and plasma refining of the silicon are in silica, carbon, graphite or silicon carbide.

## Patentansprüche

1. Verfahren zur Herstellung von Silizium in photovoltaischer Qualität aus metallurgischem Silizium, das mit Sauerstoff oder mit Chlor vergütet wurde und weniger als 500 ppm metallische Elemente enthält, umfassend:
- das Umschmelzen des vergüteten Siliziums in neutraler Atmosphäre im Elektroofen, der mit einem warmen Tiegel ausgestattet ist,
- den Transfer des umgeschmolzenen Siliziums in einen Elektroofen, der mit einem warmen Tiegel ausgestattet ist, um eine Plasmavergütung durchzuführen,
- die Plasmavergütung des umgeschmolzenen Siliziums mit einem Gemisch aus Argon und mindestens einem Gas, das zur Gruppe gehört, die vom Chlor, vom Fluor, der Salzsäure und der Flusssäure gebildet wird, als Plasmagas, wobei das Gemisch 5 bis 90 % Argon enthält,
- das Abgießen unter kontrollierter Atmosphäre in eine Form, wo das Seigerungserstarren erfolgt.

2. Verfahren nach Anspruch 1, **dadurch gekennzeichnet, dass** die Zubereitung des Siliziums mit weniger als 500 ppm metallischer Elemente durch Seigerungserstarren derart erfolgt, dass die metallischen Unreinheiten in der flüssigen Fraktion konzentriert werden.

3. Verfahren nach einem der Ansprüche 1 oder 2, **dadurch gekennzeichnet, dass** das Umschmelzen in aufeinander folgenden Losen erfolgt.

4. Verfahren nach einem der Ansprüche 1 bis 3, **dadurch gekennzeichnet, dass** das Umschmelzen und die Plasmavergütung des Siliziums an zwei unterschiedlichen Arbeitsstationen erfolgen.

5. Verfahren nach einem der Ansprüche 1 bis 4, **dadurch gekennzeichnet, dass** der Transfer des Siliziums zwischen dem Umschmelzen und der Plasmavergütung ohne Umschlag durch Verschieben einer Gruppe erfolgt, die aus der Karkasse des Ofens, dem Induktor, dem Tiegel und dem flüssigen Silizium besteht.

6. Verfahren nach einem der Ansprüche 1 bis 5, **dadurch gekennzeichnet, dass** die Plasmavergütung mit einem Gasgemisch HF-Argon und/oder HCl-Argon durchgeführt wird, das 50 bis 70 % Argon enthält.

7. Verfahren nach einem der Ansprüche 1 bis 6, **dadurch gekennzeichnet, dass** die Plasmaquelle eine Induktionsfackel ist, die durch eine elektrische Spannungsquelle mit einer Frequenz zwischen 100 kHz und 4 MHz inklusive versorgt wird.

8. Verfahren nach einem der Ansprüche 2 bis 7, **dadurch gekennzeichnet, dass** das erste Seigerungserstarren vor der Plasmavergütung mit einer Fortschrittsgeschwindigkeit der Erstarrungsfront unter 2.10⁻⁵ m/s durchgeführt wird.

9. Verfahren nach einem der Ansprüche 1 bis 8, **dadurch gekennzeichnet, dass** das Seigerungserstarren nach der Plasmavergütung mit einer Fortschrittsgeschwindigkeit der Erstarrungsfront unter 10⁻⁵ m/s durchgeführt wird.

10. Verfahren nach Anspruch 9, **dadurch gekennzeichnet, dass** die Fortschrittsgeschwindigkeit der Erstarrungsfront unter 5.10⁻⁶ m/s ist.

11. Verfahren nach einem der Ansprüche 1 bis 10, **dadurch gekennzeichnet, dass** die Arbeitsgänge des Seigerungserstarrens in einem Flammofen durchgeführt werden.

12. Verfahren nach einem der Ansprüche 1 bis 11, **dadurch gekennzeichnet, dass** die für das Umschmelzen und die Plasmavergütung des Siliziums verwendeten Elektroöfen Induktionsöfen sind.

13. Verfahren nach einem der Ansprüche 1 bis 12, **dadurch gekennzeichnet, dass** die für das Umschmelzen und die Plasmavergütung des Siliziums verwendeten Elektroofentiegel aus Silizium, aus Kohlenstoff, aus Graphit oder aus Siliziumkarbid sind.
